# FASCICULE DE BREVET EUROPEEN

(11) **EP 0 817 390 B1**
(45) Date de publication et mention de la délivrance du brevet: **14.11.2001**
(21) Numéro de dépôt: 97401509.1
(22) Date de dépôt: 27.06.1997
(51) Int. Cl.: H03M 1/44, H03M 1/16

(54) **Convertisseur analogique numérique**
Analog-Digital-Wandler
Analogue to digital converter

(30) Priorité: 28.06.1996 FR 9608083
(43) Date de publication de la demande: 07.01.1998
(73) Titulaire: Atmel Grenoble S.A., 38120 Saint Egreve (FR)
(72) Inventeur: Wingender, Marc, 94117 Arcueil Cedex (FR); Le Tual, Stéphane, 94117 Arcueil Cedex (FR)
(74) Mandataire: Guérin, Michel

(56) Documents cités:
- EP-A- 0 302 553
- EP-A- 0 406 973
- FR-A- 2 699 025
- US-A- 5 495 247

## Description

L'invention concerne les convertisseurs analogiques-numériques, c'est-à-dire les circuits électroniques capables de convertir un signal d'entrée analogique en une valeur numérique précise représentant l'amplitude du signal analogique. La valeur numérique est obtenue sous forme d'un mot de plusieurs bits, en général codé en binaire pur.

Plusieurs procédés de conversion existent, et le choix d'un procédé plutôt qu'un autre dépend des performances que l'on attend du convertisseur. Les paramètres les plus importants de ces performances sont:
- la résolution, définie par le nombre de bits du mot de sortie représentant avec exactitude l'amplitude du signal analogique ; le nombre de bits peut être de 16 à 18, voire 20, pour les convertisseurs les plus précis, et la précision est en général de + ou - 1/2 bit de poids le plus faible;
- la rapidité, c'est-à-dire le nombre d'opérations de conversion qu'on peut effectuer en une seconde;
- la consommation de puissance : un convertisseur rapide et précis consomme beaucoup plus d'énergie qu'un convertisseur lent et peu précis ; or la consommation de puissance entraîne un échauffement de la puce de circuit intégré sur laquelle est réalisé le convertisseur. Cet échauffement doit être compensé par des moyens de refroidissement qui rendent le circuit difficilement utilisable lorsqu'il y a des contraintes d'encombrement à respecter.

De plus, avec la multiplication des équipements dits "portables" (fonctionnant à l'aide de piles), le critère "consommation de puissance élevée" devient également synonyme de "faible durée de vie de l'équipement";
- et bien sûr le coût de conception et de fabrication du convertisseur lié en particulier à la surface de puce de circuit intégré utilisée par le convertisseur.

Les qualités d'un convertisseur analogique-numérique résultent d'un compromis entre les paramètres ci-dessus et un but de la présente invention est d'améliorer ce compromis.

Parmi les structures connues de convertisseurs analogiques-numériques, on peut citer :
- les convertisseurs à approximations successives, qui comparent le signal analogique d'entrée Vin successivement à des valeurs numériques approchant à chaque fois un peu mieux la valeur du signal analogique ; ces convertisseurs fonctionnent en au moins N phases si la valeur est codée sur N bits ; ils sont donc en général très lents pour des précisions dépassant 6 ou 8 bits.
- les convertisseurs "flash" qui utilisent 2^{N} comparateurs en parallèle ; les comparateurs reçoivent chacun d'une part le signal analogique et d'autre part l'une de 2^{N} tensions de références définies par un pont de 2^{N} résistances de précision ; ces convertisseurs sont très rapides (2 phases en général) mais ils sont très encombrants et consomment une puissance très importante lorsque N atteint 10 à 12 bits.
- les convertisseurs mixtes ayant un convertisseur grossier pour l'obtention des bits de poids fort et un convertisseur fin pour l'obtention des bits de poids faible ; le convertisseur grossier peut être rapide et peu précis (4 à 6 bits par exemple) ; le convertisseur fin doit être précis même s'il est moins rapide.

Parmi les convertisseurs mixtes, on a déjà proposé plusieurs solutions.

Dans une solution, le convertisseur grossier est un convertisseur flash qui fournit P bits qui sont les bits de poids fort. Cette valeur est reconvertie en signal analogique par un convertisseur numérique-analogique de P bits ; la différence entre le signal analogique Vin et cette valeur reconvertie, appelée aussi reste ou résidu, est convertie par un convertisseur fin qui détermine les bits de poids faible de la conversion ; on gagne en consommation de puissance et encombrement par rapport à un convertisseur flash, mais la conversion numérique-analogique prend du temps et nécessite un asservissement précis des gains des différentes parties de circuit (convertisseur analogique-numérique et numérique-analogique).

Dans une autre solution, le convertisseur grossier est un circuit dit "à sélection de sous-gamme parallèle". Il consiste en un circuit de sélection d'un groupe (ou gamme) de trois tensions de référence adjacentes, parmi un nombre (ou gamme) de tensions de référence supérieur à trois.

Ce circuit est apte à comparer le signal d'entrée Vin aux différentes tensions de référence, puis à sélectionner un groupe de trois tensions de référence principales adjacentes telles que Vin soit compris entre ces tensions de référence, et à établir les connexions nécessaires entre ces trois tensions de référence, trois amplificateurs différentiels, et un circuit convertisseur fin.

Le convertisseur grossier fournit (par l'intermédiaire d'un convertisseur flash) une valeur numérique indiquant le triplet de valeurs de référence entre lesquelles se situe Vin.

On obtient donc une évaluation de la gamme de référence adjacentes la plus proche possible de Vin. Une structure de ce type a déjà été décrite dans le brevet FR-A-2 699 025.

A l'intérieur de cette gamme de référence principale, on va ensuite réaliser un codage plus fin de Vin, en générant de nouvelles valeurs de références intermédiaires et équidistantes. Divers procédés existent, mais de toutes les façons il faut doubler le nombre des références intermédiaires à chaque fois que l'on veut accroître la précision de codage fin d'un facteur deux (c'est-à-dire de 1 bit).

Ces valeurs de références intermédiaires sont générées par des circuits dits "d'interpolation".

Ces derniers peuvent être des circuits d'interpolation parallèle ou série.

Dans les circuits d'interpolation parallèle, le nombre des éléments (résistance, amplificateur...) mis en oeuvre augmente comme le nombre de valeurs de référence intermédiaires, c'est-à-dire d'un facteur deux à chaque fois que la précision de codage fin augmente de 1 bit. Pour N bits, on a donc 2^{N} éléments. On est donc rapidement limité en encombrement et en consommation.

Par contre, dans les circuits à interpolation série, pour obtenir N bits d'information, seulement N éléments sont nécessaires.

On a donc, par rapport à l'interpolation parallèle, un gain considérable en encombrement et en consommation.

De telles architectures ont été décrites dans les brevets US 5 126 742 et FR-A- 2 699 025.

Dans ces circuits, le nombre de références intermédiaires générées augmente d'un facteur deux en sortie de chaque circuit d'interpolation. Ces derniers sont tous de structure identique et sont conçus pour être disposés en cascade.

Les signaux sont des fonctions périodiques de la tension analogique d'entrée Vin, d'allure sinusoïdale. Ces nouveaux signaux passent par zéro, non seulement lorsque Vin est égale aux tensions de références principales mais aussi pour des tensions de référence intermédiaires situées au milieu de l'intervalle entre deux tensions de référence principales adjacentes.

Les signaux permettent donc de fournir un bit d'information supplémentaire par rapport aux bits de poids forts obtenus par le convertisseur grossier. Les signaux ainsi obtenus en sortie d'un circuit (ou étage) d'interpolation série sont appliqués à l'étage suivant, qui est identique et a la même fonction que le précédent (création de signaux de "période" à nouveau doublée).

L'étage suivant fournit à nouveau un bit supplémentaire pour la valeur de Vin.

Ainsi de suite, plusieurs étages peuvent être mis en cascade pour obtenir les bits successifs de poids faibles de la conversion (NB : il faut noter que ces signaux "repliés" d'allure sinusoïdale consistent en des lieux de points statiques fonction des valeurs statiques de Vin, et ne sont pas une fonction du temps a priori).

Cependant, il existe un inconvénient majeur inhérent aux circuits qui effectuent le repliement : par construction, l'utilisation de signaux repliés implique l'utilisation d'éléments fortement non linéaires, caractéristique qui va à l'encontre de la fabrication de tensions intermédiaires précises.

Les nouvelles valeurs de tensions intermédiaires ne sont donc pas équidistantes, et la précision de la quantification de Vin est donc diminuée.

Or, quel que soit le procédé d'interpolation utilisé pour la conversion fine, les références intermédiaires générées entre les références principales doivent être aussi équidistantes que possible.

Toute imprécision sur ce paramètre va se traduire par une limitation dans la précision du codage fin de Vin. Or, si les circuits d'interpolation série ont effectivement résolu les problèmes d'encombrement et de consommation par rapport aux circuits d'interpolation parallèle, ils n'autorisent que très difficilement une précision de codage meilleure que 10 bits.

Cela provient directement de la non linéarité du procédé de repliement utilisé.

L'invention a pour but par conséquent de proposer une nouvelle structure de convertisseur analogique-numérique permettant d'optimiser à la fois les qualités d'encombrement réduit, de faible consommation, et de précision.

L'invention propose à cet effet un procédé de conversion analogique-numérique d'une tension d'entrée Vin, utilisant plusieurs circuits d'interpolation en cascade, caractérisé en ce que :
- on applique à l'entrée d'un circuit d'interpolation de rang k trois paires de signaux analogiques issus de trois paires de sorties du circuit d'interpolation précédent de rang k-1, les signaux d'une paire ayant des valeurs égales lorsque la tension Vin est égale à l'une de trois tensions de références principales de rang k-1 associées chacune à une paire respective, ces trois tensions définissant entre elles un intervalle composé de deux demi-intervalles de tension de rang k-1,
- on produit, à partir de ces trois paires de signaux, P = 2^{p}+1 paires de signaux d'interpolation (p>1, P>3), chaque paire comprenant deux signaux d'interpolation qui varient symétriquement et de manière monotone en fonction de la tension Vin, les signaux d'une paire étant égaux lorsque la tension Vin est égale à une tension de référence associée à cette paire, les P tensions de référence associées aux P paires étant sensiblement d'une part les trois tensions de référence principales de rang k-1 et d'autre part au moins deux tensions intermédiaires situées au milieu des demi-intervalles définis par les trois tensions de référence principales de rang k-1, ces P tensions de référence permettant de définir 2^{p}-1 intervalles de tension de largeur égale à 1/2^{p-1} intervalle de rang k-1,
- on détermine en fonction des niveaux des trois paires de signaux d'entrée quel est, parmi les 2^{P} -1 intervalles, l'intervalle de tensions qui encadre de plus près la tension d'entrée Vin, cet intervalle étant composé de deux demi-intervalles délimités par trois tensions de référence parmi P, ces trois tensions étant appelées tensions de référence de rang k,
- on sélectionne, parmi les P paires, les trois paires associées aux trois tensions de référence de rang k, et on applique ces trois paires à la sortie du circuit d'interpolation de rang k.

La structure de convertisseur correspondante comprend plusieurs circuits d'interpolation en cascade, avec au moins un circuit d'interpolation de rang k comportant
- trois paires d'entrées recevant comme signaux d'entrée trois paires de signaux de sortie d'un circuit d'interpolation précédent, les signaux d'une paire ayant des valeurs égales lorsque la tension Vin est égale à l'une de trois tensions de références principales de rang k-1 associées chacune à une paire respective, ces trois tensions définissant entre elles un intervalle composé de deux demi-intervalles de tension de rang k-1,
- des moyens pour établir, à partir des signaux d'entrée, P = 2^{p}+1 paires de signaux d'interpolation (p>1, P>3), chaque paire comprenant deux signaux d'interpolation qui varient symétriquement et de manière monotone en fonction de la tension Vin, les signaux d'une paire étant égaux lorsque la tension Vin est égale à une tension de référence associée à cette paire, les P tensions de référence associées aux P paires étant sensiblement d'une part les trois tensions de référence principales de rang k-1 et d'autre part (P-3) tensions de référence intermédiaires, les P tensions de référence permettant de définir 2^{p} - 1 intervalles de tension de largeur égale à 1/2^{p-1} intervalle de rang k-1,
- des moyens de décision pour déterminer en fonction des niveaux des trois paires de signaux d'entrée quel est, parmi les 2^{p}-1 intervalles, l'intervalle de tensions qui encadre de plus près la tension d'entrée Vin, cet intervalle étant composé de deux demi-intervalles délimités par trois tensions de référence parmi P, ces trois tensions étant appelées tensions de référence de rang k,
- et des moyens pour sélectionner, parmi les P paires, les trois paires associées aux trois tensions de référence de rang k, pour les appliquer à la sortie du circuit d'interpolation de rang k.

Appliquée au cas où p = 2 et P=5, l'invention propose un convertisseur analogique-numérique, qui possède une entrée pour recevoir une tension analogique Vin à convertir, caractérisé en ce qu'il comporte une succession de circuits d'interpolation et de sélection en cascade, avec au moins un circuit d'interpolation et de sélection de rang k comportant :
- trois paires d'entrées recevant comme signaux d'entrée trois paires de signaux de sortie d'un circuit d'interpolation et de sélection de rang k-1, les signaux d'une paire ayant des valeurs égales lorsque la tension à convertir Vin est égale à l'une de trois tensions de référence principales de rang k-1, ces trois tensions définissant entre elles un intervalle composé de deux demi-intervalles de tensions de rang k-1,
- des moyens pour établir à partir des signaux d'entrée cinq paires de signaux dits signaux d'interpolation, chaque paire comprenant deux signaux d'interpolation qui varient symétriquement et de manière monotone en fonction de la tension Vin, les signaux d'une paire étant égaux lorsque la tension Vin est égale à une tension de référence associée à cette paire, les cinq tensions de référence associées aux cinq paires étant sensiblement d'une part les trois tensions de référence principales de rang k-1 et d'autre part deux tensions de référence intermédiaires situées au milieu des demi-intervalles définis par les trois tensions de référence principales de rang k-1, ces cinq tensions de référence permettant de définir trois intervalles de tension de largeur égale à un des demi-intervalles de rang k-1,
- des moyens de décision pour déterminer parmi les cinq tensions de référence quelles sont les trois tensions qui définissent entre elles un intervalle de largeur égale à un demi-intervalle de rang k-1 et qui encadrent de plus près la tension d'entrée Vin à convertir, les tensions de référence ainsi sélectionnées étant trois tensions de référence principales de rang k,
- et des moyens pour sélectionner parmi les cinq paires de signaux d'interpolation les trois paires telles que les signaux d'une paire soient égaux lorsque la tension Vin est égale à l'une des tensions de référence principales de rang k.

Cette structure en cascade utilise pour chaque étage des signaux monotones qui se croisent en un seul point, contrairement à l'art antérieur dans lequel on utilise des signaux repliés périodiques qui se croisent en de multiples points.

Le circuit d'interpolation et de sélection de rang k permet de fournir un ou deux bits d'information de rang k liés à la valeur de la tension à convertir Vin; en effet les circuits de rang successifs croissants déterminent à chaque fois un intervalle de tensions qui encadre de plus près la tension Vin et l'intervalle défini pour le circuit de rang k est moitié de l'intervalle défini pour le rang k-1.

Le convertisseur ainsi défini peut être utilisé comme convertisseur autonome, à lui seul, ou bien être utilisé comme convertisseur fin dans une structure comportant un convertisseur grossier pour les bits de poids forts et un convertisseur fin pour les bits de poids faibles.

Le circuit d'interpolation et de sélection de rang 1 reçoit de préférence comme signaux d'entrée les sorties différentielles de trois amplificateurs différentiels qui reçoivent sur une première entrée la tension à convertir Vin, et sur une deuxième entrée chacun une de trois références de tension primaires. Ces amplificateurs fournissent chacun deux tensions de sortie qui varient symétriquement et de manière monotone en fonction de la tension à convertir Vin. Les références de tension primaires sont espacées les unes des autres de telle sorte que les courbes de variation de tensions de sortie de l'amplificateur correspondant à la référence centrale croisent les courbes de variation des tensions de sortie des deux autres amplificateurs dans une zone de variation linéaire de ces tensions de sortie.

Les circuits d'interpolation comportent en pratique cinq amplificateurs différentiels, un circuit de décision, et un circuit de sélection commandé par le circuit de décision pour orienter vers les sorties du circuit les sorties de trois amplificateurs différentiels sélectionnés parmi les cinq.

Mais il est possible de généraliser la structure de conversion selon l'invention en utilisant des circuits d'interpolation et de décision qui comportent un plus grand nombre d'amplificateurs différentiels et qui permettent de sélectionner un intervalle de tensions de rang k parmi sept, voire même parmi quinze au lieu d'un intervalle parmi trois. Cela peut être utile pour réduire le nombre d'étages en cascade, mais cela augmente évidemment le nombre d'amplificateurs différentiels utilisés dans chaque étage puisqu'il faut produire neuf ou dix-sept tensions de référence parmi lesquelles on va en sélectionner trois.

Enfin, on notera que l'art antérieur divulgue, dans la demande de brevet européenne EP-A-0 406 973 un convertisseur qui utilise le principe du chevauchement de gammes de tensions pour chaque approximation successive et qui n'utilise pas le principe de la sélection de trois paires de signaux de sortie parmi 2^{p} + 1 pour constituer trois entrées d'un étage suivant.

D'autres caractéristiques et avantages de l'invention apparaîtront à la lecture de la description détaillée qui suit et qui est faite en référence aux dessins annexés dans lesquels :
- la figure 1 représente un schéma de l'architecture générale du convertisseur selon l'invention;
- la figure 2 représente un schéma typique d'amplificateur différentiel tel que l'amplificateur A1 de la figure 1;
- la figure 3 représente les courbes de variation de tension de sortie d'un des amplificateurs différentiels d'entrée en fonction de la tension Vin à convertir;
- la figure 4 représente la superposition des courbes de variation des trois amplificateurs différentiels d'entrée;
- la figure 5 est un schéma explicatif du principe d'approximation successive de Vin par sélection de gammes de tension;
- la figure 6 représente les courbes de variation des signaux de sortie du circuit d'interpolation et de sélection de rang 1, avec les autres signaux élaborés dans ce circuit mais non sélectionnés;
- la figure 7 représente la configuration générale d'un circuit d'interpolation et de sélection tel que le circuit CIS1 de la figure 1;
- la figure 8 représente un schéma d'amplificateur différentiel à linéarité améliorée utilisé dans l'invention;
- la figure 9 représente un schéma pratique de circuit de sélection de trois paires de signaux parmi cinq paires elles-mêmes élaborées à partir de trois paires de signaux d'entrée;
- la figure 10 représente un circuit de décision permettant de sélectionner trois paires de signaux parmi cinq;
- la figure 11 représente un diagramme de tensions expliquant le fondement logique du circuit de décision de la figure 10;
- la figure 12 représente une structure de décodeur réalisée à partir d'additionneurs en cascade pour l'obtention d'une valeur numérique de Vin;
- la figure 13 représente une variante de réalisation de circuit d'interpolation et de sélection permettant la sélection de trois paires de signaux parmi neuf pour la sélection d'une sous-gamme parmi sept.

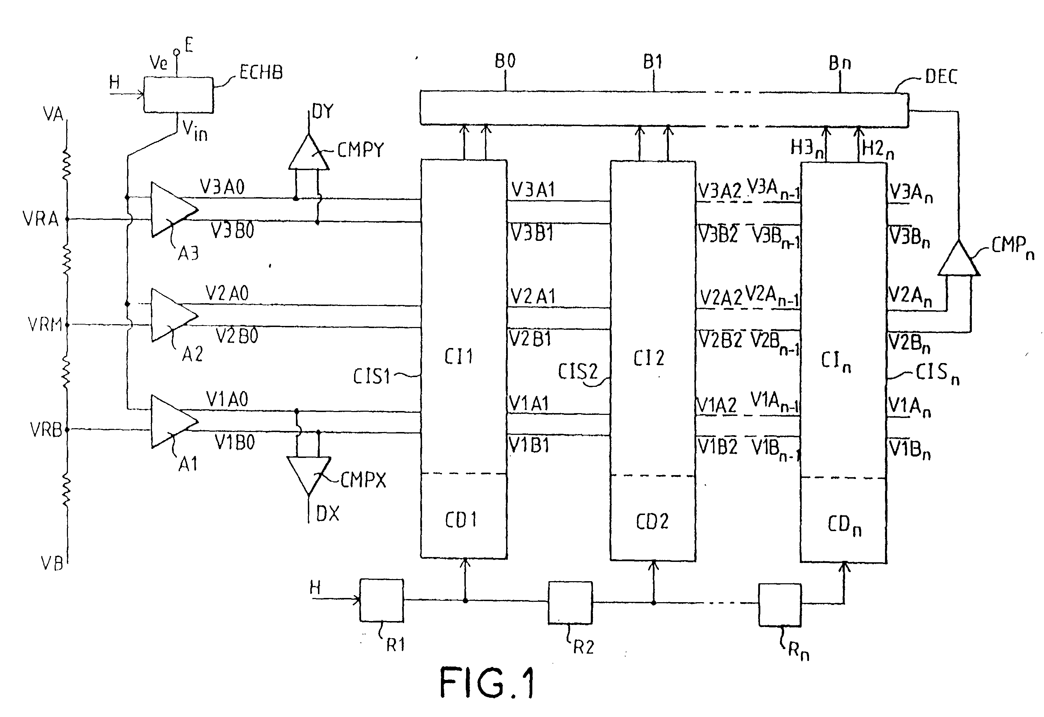

La structure générale du convertisseur selon l'invention est représentée à la figure 1.

La fonction de ce convertisseur est de fournir un signal numérique de n bits représentant sous forme numérique la valeur de l'amplitude d'un signal analogique d'entrée Vin. Les n bits représentent selon un code binaire une valeur de Vin parmi 2ⁿ valeurs distribuées régulièrement entre deux valeurs de référence principales VRA et VRB.

Le signal d'entrée Vin peut prendre des valeurs quelconques entre deux valeurs extrêmes Vext1 et Vext2 qui peuvent aller bien au delà de la gamme de valeurs situées entre VRA et VRB, mais de toutes façons la sortie du convertisseur ne fournit une représentation numérique de Vin que si Vin est située entre VRA et VRB. On verra toutefois que le convertisseur peut aussi fournir un signal de dépassement par le haut ou par le bas indiquant si Vin est en dehors de la gamme VRA à VRB.

Les tensions de référence principales VRA et VRB, ainsi qu'une autre tension de référence principale VRM équidistante des valeurs VRA et VRB, sont appliquées chacune respectivement à une première entrée d'un amplificateur différentiel respectif A1 (pour VRB), A2 (pour VRM) et A3 (pour VRA).

Les tensions de référence sont produites de manière quelconque, mais de préférence grâce à un pont de résistances de précision alimenté entre deux tensions de référence globales VA et VB; les prises intermédiaires de ce pont sont calculées pour obtenir les tensions de référence principales VRB, VRM, et VRA.

Chaque amplificateur différentiel possède une deuxième entrée sur laquelle est appliquée la tension d'entrée Vin à convertir. De préférence, cette tension est issue de la sortie d'un échantillonneur-bloqueur ECHB; la tension Vin de sortie reproduit périodiquement et maintient constante, entre deux instants d'échantillonnage successifs, la valeur que possède la tension Ve à l'entrée E de l'échantillonneur aux instants d'échantillonnage. Dans la suite, on considérera que c'est la tension Vin qui constitue le signal d'entrée du convertisseur, bien que le signal analogique à convertir soit en réalité plutôt le signal Ve.

L'échantillonneur-bloqueur ECHB permet de maintenir momentanément constante la valeur du signal à convertir pour permettre d'effectuer la conversion sur une valeur d'entrée stable.

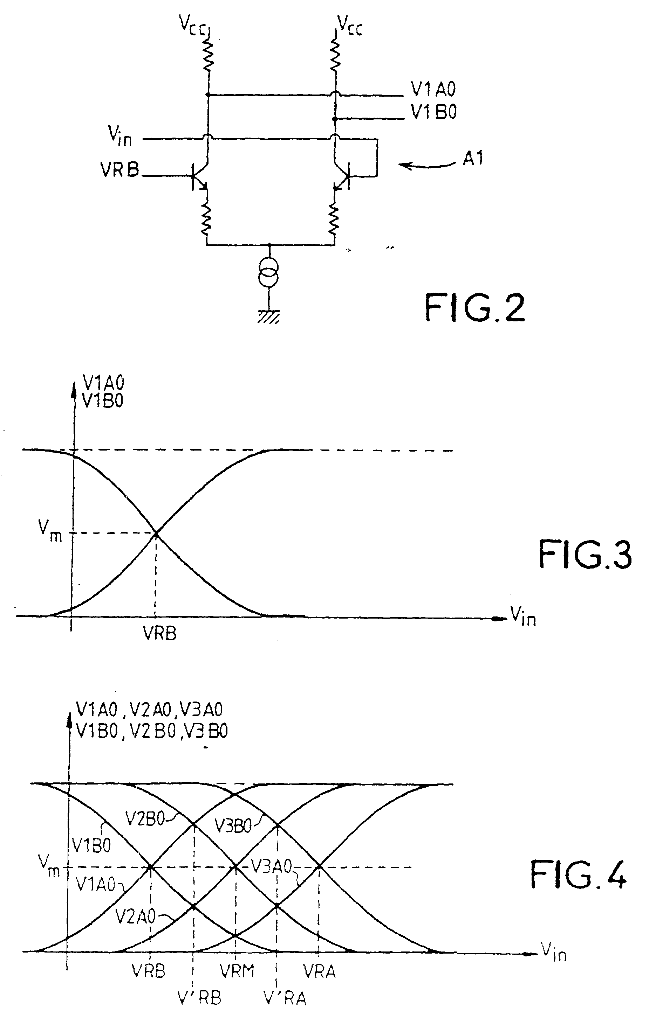

Les amplificateurs différentiels A1, A2, A3, sont identiques. Les particularités de leur fonction de transfert (fonction représentant l'évolution de leurs tensions de sortie en fonction de leur tension d'entrée) seront précisées plus loin. Mais d'ores et déjà on peut dire que ces fonctions de transfert sont obtenues avec des amplificateurs de type très courant constitués dans leur version la plus simple par exemple par une paire de branches différentielles alimentées globalement par une source de courant constant, avec un transistor d'entrée et une charge résistive dans chaque branche. La figure 2 représente un tel amplificateur différentiel A1.

Chaque amplificateur différentiel possède deux sorties différentielles. Il fournit sur ces sorties deux tensions qui varient symétriquement en fonction de la valeur de Vin, sensiblement linéairement autour d'une valeur moyenne Vm, commune pour les deux sorties et identique pour les trois amplificateurs; cette valeur moyenne commune est celle qui est obtenue en sortie d'un amplificateur lorsque les tensions sur les deux entrées de cet amplificateur sont égales. De plus, les amplificateurs sont tels que les tensions sur les sorties différentielles varient de manière monotone avec Vin pour toute la gamme de valeurs possibles de Vin (dans l'intervalle VRB à VRA et, au delà, dans l'intervalle Vext1 à Vext2 des valeurs possibles pour Vin).

La figure 3 représente les courbes de variation des deux tensions différentielles de sortie (V1A0, V1B0) pour un amplificateur unique (A1); Les courbes ne représentent pas des formes d'onde temporelles des tensions de sortie mais les évolutions de ces tensions en fonction de la valeur de la tension d'entrée Vin. Ces courbes V1A0, V1B0 représentent les fonctions de transfert classiques d'un amplificateur différentiel symétrique simple à deux transistors d'entrée, ayant une entrée portée à la tension de référence VRB et l'autre à Vin. Les courbes V1A0, V1B0 sont symétriques, monotones, et elles se coupent en un point d'abscisse VRB et d'ordonnée Vm, où Vm est la valeur du potentiel commun des sorties pour une tension d'entrée différentielle nulle (Vin = VRB).

Les portions de courbe, aux alentours du point où elles se rencontrent, et même largement au delà, sont linéaires, puis, plus on s'éloigne de ce point, plus on tend asymptotiquement vers deux valeurs extrêmes de potentiel de sortie qui dépendent des tension et courant d'alimentation de l'amplificateur. Les pentes des portions linéaires sont plus faibles si une résistance d'émetteur est placée en série avec l'émetteur du transistor dans chaque branche de l'amplificateur. La linéarité de la portion linéaire est en outre améliorée avec une telle résistance d'émetteur et il pourra donc être avantageux de prévoir des amplificateurs différentiels avec résistances d'émetteur.

Il est important d'avoir une bonne linéarité et une bonne égalité de la valeur moyenne Vm pour les trois amplificateurs et des circuits de correction de linéarité peuvent de préférence être associés aux amplificateurs A1, A2, A3 (voir plus loin).

La figure 4 représente en superposition les six tensions de sortie correspondant aux trois amplificateurs : (V1A0, V1B0) pour A1, (V2A0, V2B0) pour A2, (V3A0, V3B0) pour A3. Ces courbes sont identiques mais décalées latéralement les unes par rapport aux autres puisqu'elles sont centrées sur les trois tensions de référence primaires différentes VRB, VRM, VRA.

Des courbes de variation des signaux de sortie des amplificateurs A1, A2, A3, on tire les remarques qui suivent.

D'abord, on peut prévoir dans le circuit de la figure 1 un comparateur CMPX recevant les sorties du premier amplificateur A1 pour fournir un signal logique DX de dépassement vers le bas (Vin < VRB), et également un comparateur CMPY recevant les sorties du troisième amplificateur pour fournir un signal logique DY de dépassement vers le haut (Vin>VRA).

Ensuite, si les amplificateurs A1, A2, A3 sont linéaires dans une gamme assez large et identiques entre eux, on a les particularités suivantes:
- les courbes de la paire symétrique V1A0 et V1B0 se coupent au centre de leurs zones linéaires ; et de même les courbes des paires V2A0, V2B0 et V3A0, V3B0 ;
- les courbes de la paire croisée V1A0, V2B0 (ou de l'autre paire croisée V2A0, V1B0) se coupent également dans leurs zones linéaires (mais pas en leur centre) pour des valeurs de Vin égales à une tension de référence intermédiaire fictive V'RB située au milieu du demi-intervalle VRB, VRM ;
- les courbes de la paire croisée V2A0, V3B0 (ou réciproquement V3A0, V2B0) se coupent dans leurs zones linéaires (mais pas en leur centre) pour des valeurs de Vin égales à une autre tension de référence intermédiaire fictive V'RA située au milieu du demi-intervalle VRM, VRA.

Si on applique la paire symétrique de signaux V1A0, V1B0 à un nouvel amplificateur différentiel symétrique linéaire, cet amplificateur fournira une nouvelle paire de signaux variant en fonction de Vin de manière monotone, symétrique, les courbes de variation de ces signaux se coupant encore au centre de leurs zones linéaires pour Vin égale à la tension de référence principale VRB. Pour la paire V2A0, V2B0 c'est la même chose pour Vin égale à VRM, et pour la paire V3A0, V3B0, les courbes se coupent en leur centre pour Vin égale à VRA.

Si on applique la paire croisée V1A0, V2B0 à un amplificateur différentiel symétrique linéaire, cet amplificateur fournira une nouvelle paire de signaux variant en fonction de Vin de manière monotone, symétrique ; les courbes de variation de ces signaux se coupent au centre de leurs zones linéaire (ce qui n'était pas le cas pour les courbes V1A0, V2B0 elles-mêmes) pour Vin = V'RB. De même pour la paire croisée V2A0, V3B0 qui, appliquée à un amplificateur différentiel linéaire symétrique, produit deux signaux dont les courbes de variation, monotones et symétriques, se coupent en leur centre pour Vin = V'RA.

Les amplificateurs différentiels supplémentaires dont on vient de parler peuvent donc servir à réaliser cinq paires de signaux qu'on peut appeler signaux d'interpolation parmi lesquels :
- trois paires sont tout-à-fait analogues aux signaux de sortie des amplificateurs A1, A2, A3 et les croisements de leurs courbes de variation correspondent aux trois références de tension principales VRB, VRM, VRA.
- deux paires supplémentaires sont très semblables aux trois premières mais leurs courbes de variation sont intercalées au milieu des trois autres, leurs croisements se produisant l'une pour Vin = V'RA et l'autre pour Vin = V'RB c'est-à-dire pour les deux tensions de référence fictives intermédiaires.

On reviendra plus loin sur ces courbes de variation des signaux de sortie de ces amplificateurs différentiels supplémentaires, qui, comme on va le voir, appartiennent à une cellule d'interpolation CI1 faisant elle-même partie d'un circuit d'interpolation et de sélection CIS1 dans une structure comportant plusieurs circuits d'interpolation et de sélection en cascade.

La gamme de tensions de référence dans laquelle se situent les cinq références est la gamme VRB, VRM, VRA qu'on peut appeler gamme de rang 0, divisée en deux demi-intervalles de rang 0 qui sont les demi-intervalles (VRB, VRM) et (VRM, VRA).

Selon l'invention, on sélectionne à l'intérieur de cette gamme de rang 0 une gamme de rang 1, deux fois plus réduite, donc de largeur égale à un demi-intervalle de rang 0, cette gamme de rang 1 ayant pour extrémités deux des cinq références de tension de la gamme de rang 0 et pour milieu une autre de ces cinq références.

Il y a trois possibilités : gamme (VRB, VR'B, VRM) ; gamme (VR'B, VRM, VR'A) ; ou gamme (VRM, VR'A, VRA).

On choisit la gamme qui encadre de plus près la tension Vin, ce qui est possible en comparant entre elles les valeurs des trois paires de signaux de sortie des amplificateurs A1, A2, A3 (des explications détaillées seront données plus loin au sujet de cette comparaison). Les trois gammes se recouvrent, c'est-à-dire que la gamme centrale chevauche les deux autres.

Choisir une gamme parmi trois revient tout simplement à sélectionner trois paires de signaux parmi cinq paires de signaux élaborées par cinq amplificateurs différentiels dans le circuit d'interpolation CIS1.

Le circuit d'interpolation de rang 1 CIS1 élabore donc cinq paires de signaux, grâce à une cellule d'interpolation CI1 à cinq amplificateurs différentiels, mais il ne fournit à sa sortie que trois paires sélectionnées qu'on appellera V1A1, V1B1 ; V2A1, V2B1 ; V3A1, V3B1. Et les paires sélectionnées sont celles qui correspondent à trois références de tension encadrant du plus près possible la tension d'entrée Vin.

Un circuit de décision CD1 est donc associé à la cellule CI1 pour commander la sélection de trois paires parmi cinq, l'ensemble CD1 et CI1 constituant le circuit CIS1 d'interpolation de rang 1.

On a donc élaboré trois paires de signaux dont les courbes de variation en fonction de Vin ont la même allure que les courbes des signaux de sortie des trois amplificateurs A1, A2, A3 et se croisent pour trois références de tension sélectionnées qu'on appellera maintenant références de tension principales de rang 1. Ces références sont fictives et, de même que les trois références réelles VRB, VRM, VRA définissaient un intervalle de tension de rang 0 d'amplitude VRA-VRB, ces trois références fictives définissent un intervalle de tensions, ou gamme de tensions, de rang 1, moitié de la gamme de rang 0 et centrée au mieux sur la tension Vin.

Le circuit d'interpolation CIS1 est par ailleurs capable de fournir une information sur la gamme de tensions sélectionnée (puisqu'il la sélectionne lui-même) et on comprend que cette information (deux bits par exemple pour définir la sélection d'une gamme parmi trois) peut être utilisée pour la conversion analogique-numérique de Vin puisqu'elle correspond à un choix de gamme la mieux centrée sur Vin. L'information numérique ainsi obtenue correspond bien sûr à une approximation grossière de Vin donc à un poids fort de la conversion. On expliquera plus loin comment on exploite plus précisément cette information, mais d'ores et déjà on peut indiquer que l'information de sélection de gamme est transmis à un circuit de décodage DEC qui élabore la valeur numérique binaire B0, B1, ... Bn de la conversion analogique-numérique de Vin

Il ne reste plus qu'à utiliser les trois paires de signaux de sortie du circuit CIS1 pour les appliquer à une succession d'autres circuits d'interpolation en cascade CIS2, ... CISₙ, identiques au circuit CIS1. Chaque circuit reçoit trois paires de signaux, en élabore cinq, et en sélectionne trois pour le circuit suivant. A chaque fois les trois paires de signaux ont la même allure qu'à la figure 4, c'est-à-dire que :
- leurs courbes de variation selon Vin sont monotones,
- les courbes des signaux d'une paire sont symétriques et se croisent donc en leur centre, définissant une référence principale, les trois paires définissant trois références principales;
- les courbes des signaux d'une paire croisent les courbes des signaux de la paire la plus proche dans leurs zones linéaires, en définissant deux références intermédiaires,
- les courbes des trois paires sont resserrées avec des espacements à chaque fois réduits de moitié par rapport à l'espacement des courbes dans l'étage précédent,
- et Vin est toujours situé dans la gamme définie par les trois références principales, gamme qui se resserre à chaque nouvel étage.

Par conséquent, un circuit d'interpolation et de sélection CISₖ de rang k reçoit trois paires de signaux V1Aₖ₋₁, V1Bₖ₋₁, V2Aₖ₋₁, V2Bₖ₋₁, V3Aₖ₋₁, V3Bₖ₋₁ ; les paires de signaux varient en fonction de Vin selon des courbes monotones symétriques qui se croisent au centre de leurs zones linéaires pour trois tensions de référence principales de rang k-1 définissant une gamme de rang k-1. Le circuit CISₖ élabore cinq paires de signaux, en sélectionne trois qui sont les signaux (V1Aₖ, V1Bₖ), (V2Aₖ, V2Bₖ), (V3Aₖ, V3Bₖ).

On notera que les trois paires de tension de sortie sélectionnées ont des courbes de variation en fonction de Vin qui se croisent toutes dans une zone linéaire de ces courbes, ce qui permet, dans l'étage suivant de se servir de ces signaux pour faire d'autres tensions d'interpolation définies avec précision.

Le circuit CISₖ fournit par ailleurs des informations (deux bits en principe) sur la gamme de tensions sélectionnée pour le rang k et ces informations sont transmises au décodeur DEC.

Il n'y a pas de circuit de rang 0 autre que les amplificateurs A1, A2, A3, et le circuit de rang 1 reçoit donc directement les sorties des amplificateurs A1, A2, A3. Le dernier circuit d'interpolation, de rang n, peut fournir, grâce à un comparateur CMPₙ, un bit d'information sur la position de Vin par rapport à la référence de tension médiane du groupe de tensions de référence principales de rang n. Cette information est obtenue en comparant les signaux de sortie V2Aₙ et V2Bₙ du circuit CISₙ de rang n. Elle est transmise au décodeur DEC qui en a besoin pour l'élaboration de la valeur numérique (B0, B1 ... Bₙ) de Vin.

Etant donné que le convertisseur est composé d'une cascade de circuits d'interpolation, la logique de sélection de gamme doit fonctionner séquentiellement d'un étage au suivant, l'élaboration d'une gamme de rang k n'ayant de sens que si la gamme de rang k-1 a été choisie auparavant. Le convertisseur fonctionne donc sous le contrôle d'un séquenceur et les signaux d'horloge appliqués à un étage de rang k sont retardés d'un court instant, par un circuit de retard Rₖ, par rapport aux signaux d'horloge appliqués à l'étage précédent. Ces circuits de retard (R1, R2, ...Rn) sont représentés sur la figure 1.

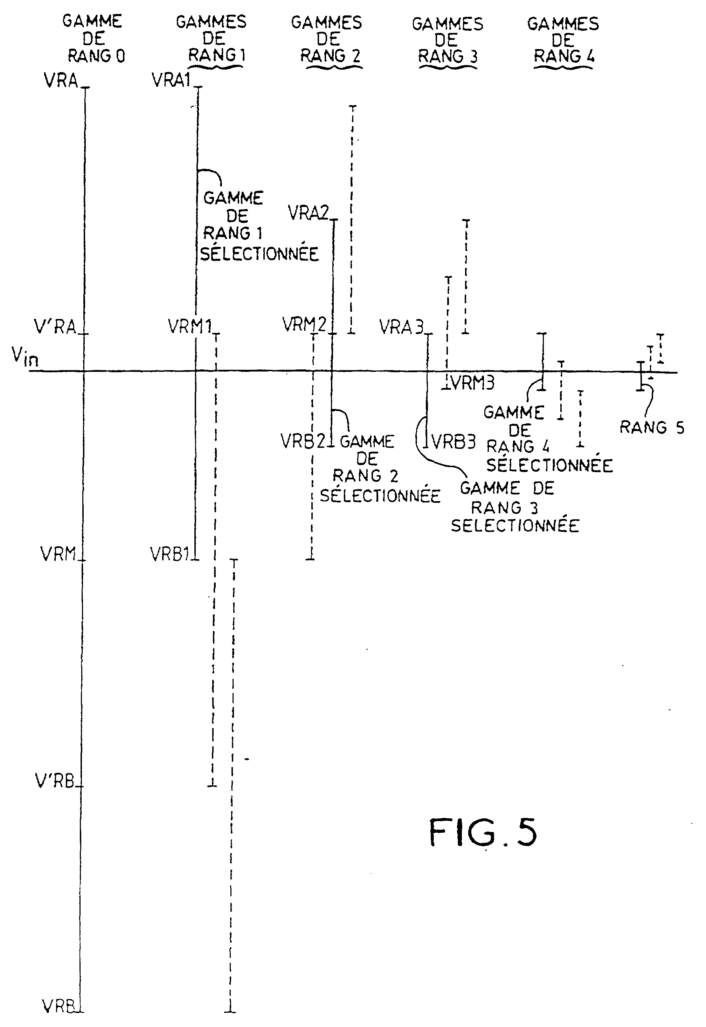

La figure 5 est un diagramme explicatif reprenant sous forme imagée la notion de gammes de tensions d'amplitude successives réduites de moitié, une gamme de rang k se décomposant en trois gammes de rang k+1 qui se chevauchent, parmi lesquelles une gamme de rang k+1 est choisie du fait qu'elle encadre de plus près la tension Vin.

La figure 5 illustre symboliquement le principe de sélection de gammes décroissantes autour de Vin, sur lequel repose l'architecture en cascade de la figure 1.

Vin est au départ situé dans la gamme de tensions VRB, VRM, VRA représentée en échelle verticale sur la figure 5. Si Vin n'est pas dans cette gamme, le comparateur CMPX ou CMPY l'indique.

La gamme VRB, VRM, VRA est la gamme de rang 0 composée de deux demi-intervalles de rang 0 : VRB, VRM et VRM, VRA.

L'utilisation des trojs paires de signaux issus des amplificateurs A1, A2, A3 permet de définir, comme on l'a expliqué ci-dessus, à l'intérieur du circuit CIS1 de rang 1, cinq tensions de références fictives (trois références principales qui sont VRB, VRM et VRA et deux références intermédiaires V'RB, V'RA situées au milieu des demi-intervalles VRB, VRM et VRM, VRA.

Ces cinq références définissent trois gammes de tension de rang 1, qui ont chacune une amplitude moitié de la gamme de rang 0, qui se chevauchent mutuellement, et qui comprennent deux demi-intervalles de rang 1 d'amplitude moitié des demi-intervalles de rang 0.

Ces gammes de tension se recouvrent et la tension Vin peut être située à l'intérieur d'une ou deux de ces gammes. Elle est cependant encadrée de plus près par l'une (celle dont le milieu est le plus proche de Vin).

Une fonction du circuit d'interpolation et de sélection, et plus précisément une fonction du circuit de décision associé, est de sélectionner cette gamme qui encadre de plus près Vin. Sur la figure 5, c'est la gamme (VRM, VRA) avec une référence intermédiaire V'RA au milieu.

Cette gamme est la gamme de rang 1 sélectionnée et pour la cohérence de notation, on peut appeler VRB₁, VRM₁, VRA₁, les trois références de tension fictives principales de rang 1 qu'elle définit pour le circuit d'interpolation de rang 2 qui suit.

Ces trois tensions principales de rang 1 sont théoriquement VRM, VR'A et VRA, mais du fait des erreurs de linéarité, les tensions de référence fictives définies par le circuit d'interpolation peuvent ne pas être rigoureusement égales aux références de rang 0, et c'est pourquoi les références de rang 1 ont été appelées VRB1, VRM1, VRA1.

Cette sélection d'une gamme parmi trois correspond en pratique, à l'intérieur du circuit d'interpolation et de sélection de rang 1 CIS1, à la sélection de trois paires de signaux parmi cinq paires élaborées dans ce circuit, les trois paires sélectionnées constituant la sortie du circuit CIS1 et étant appliquées à l'entrée du circuit CIS2.

De la même manière, à partir des trois paires de signaux appliquées au circuit CIS2 de rang 2, on peut établir cinq paires de signaux et sélectionner trois paires de signaux de sortie de rang 2, V1A₂, V1B₂, V2A₂, V2B₂, V3A₂, V3B₂ correspondant à une gamme de tension de rang 2 d'amplitude moitié de la gamme de rang 1, divisée en deux demi-intervalles repérés par les références de tension VRB₂, VRM₂, VRA₂, la gamme sélectionnée étant celle qui approche de plus près Vin.

Ainsi de suite, on choisit des gammes de plus en plus restreintes autour de Vin.

Le choix de la gamme la plus appropriée pour le rang k se fait par le circuit de décision CDk associé à la cellule d'interpolation Clk de rang k. Ce circuit de décision prend la décision en fonction de la valeur des tensions appliquées à l'entrée du circuit de rang k.

Le chevauchement des gammes permet de limiter la précision nécessaire pour les circuits de décision ; cette précision n'a pas besoin d'être du même ordre que la précision de conversion du convertisseur.

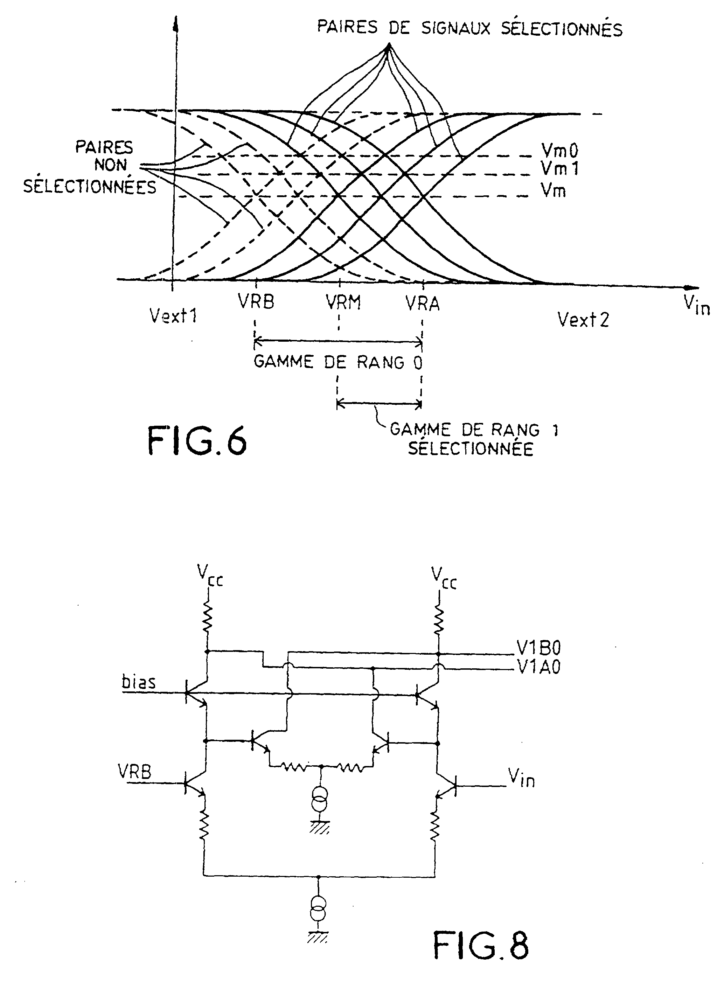

Sur la figure 6, on a représenté les cinq paires de signaux qui sont élaborées dans le circuit d'interpolation CIS1, parmi lesquels trois (en traits pleins) sont sélectionnées parce qu'elles définissent une gamme de rang 1 qui encadre le mieux possible Vin, et deux (en traits pointillés) sont inutilisées parce qu'elles servent à définir uniquement les deux gammes non sélectionnées.

Les cinq paires de signaux ont des courbes de variation (en fonction de Vin) semblables à celles de la figure 4.

Bien que les courbes de la figure 6 aient été représentées avec des pentes de variation (aux croisements) identiques à celles de la figure 4, on peut noter que les pentes peuvent être différentes sans changer le principe de fonctionnement. Plus généralement, la pente de variation des signaux d'un étage en fonction de Vin n'est pas forcément la même que la pente de variation des signaux de l'étage précédent en fonction de Vin. De préférence elle est deux fois plus forte. On reviendra plus loin sur ce point.

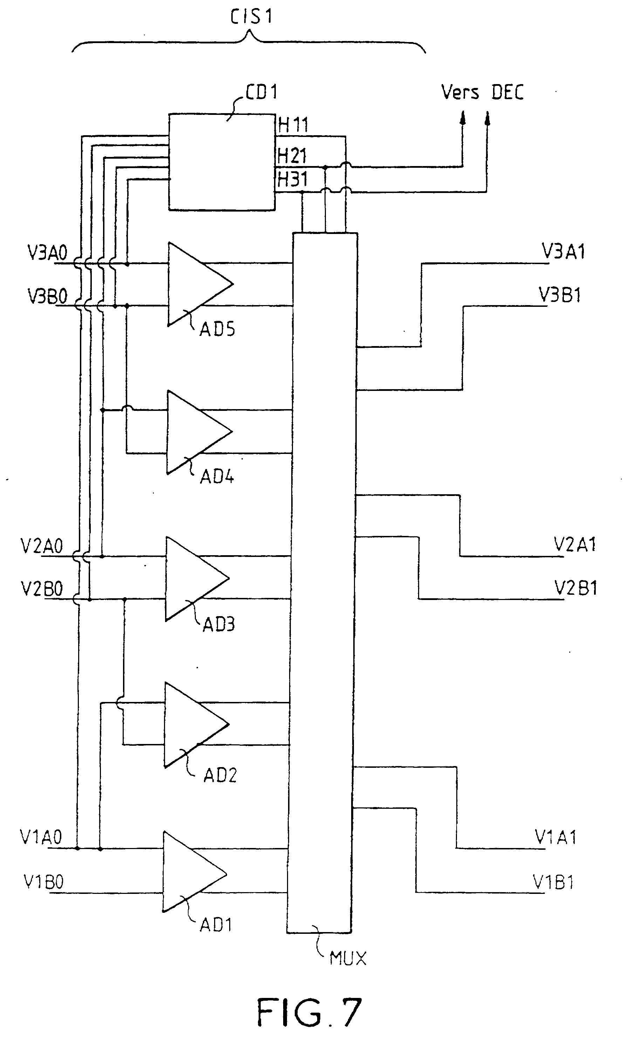

La figure 7 représente la constitution schématique d'un circuit d'interpolation et de sélection, par exemple le circuit de rang 1 CIS1, les autres pouvant être identiques.

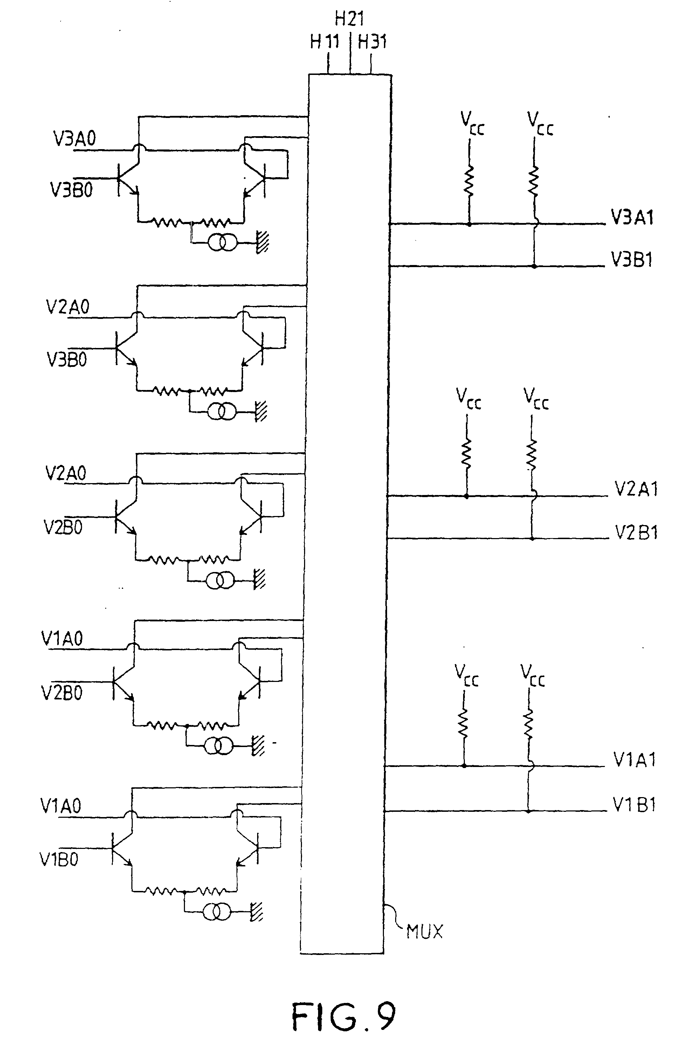

Le circuit comporte cinq amplificateurs différentiels AD1, AD2, AD3, AD4, AD5. Les amplificateurs peuvent être du type de la figure 2, ou d'un type amélioré du point de vue de la linéarité, comme celui de la figure 8 puisque la linéarité est un facteur de précision important dans la structure de l'invention.

Les amplificateurs AD1, AD3, AD5 reçoivent en entrée les paires de signaux symétriques V1A0, V1B0 ; V2A0, V2B0 ; V3A0, V3B0 respectivement. Les amplificateurs AD2 et AD4 reçoivent des paires croisées V1A0, V2B0 et V2A0, V3B0 respectivement.

Ils produisent cinq paires de signaux appliquées à un multiplexeur MUX qui en sélectionne trois sous la commande du circuit de décision CD1. Les trois paires de signaux sélectionnés sont des signaux qu'on appelle V1A1, V1B1; V2A1, V2B1; V3A1, V3B1. Ils sont appliqués comme signaux d'entrée à l'étage qui suit.

Le circuit de décision CD1 reçoit les signaux d'entrée V1A0, V1B0, V2A0, V2B0, V3A0, V3B0 (ou seulement certains d'entre eux compte tenu de ce qu'ils forment des paires symétriques), et il élabore des signaux logiques H1₁, H2₁, H3₁ et éventuellement leurs compléments. Ces signaux commandent le multiplexeur MUX : le signal H1₁ est au niveau logique haut si la gamme de tension inférieure est sélectionnée ; le signal H2₁ est au niveau haut si c'est la gamme intermédiaire qui est sélectionnée ; et le signal H3₁ est au niveau haut si c'est la gamme supérieure.

Les signaux élaborés par le circuit CD1, ici plus précisément les signaux H2₁ et H3₁, constituent par ailleurs des informations logiques binaires fournies au décodeur DEC de la figure 1 pour élaborer la valeur numérique de Vin.

De la même façon, un circuit ClSk de rang k engendre des signaux de sélection H1ₖ, H2ₖ, H3ₖ parmi lesquels les signaux H2ₖ et H3ₖ sont transmis au décodeur DEC.

La figure 8 représente une constitution possible des amplificateurs AD1 à AD5, ou des amplificateurs A1, A2, A3, avec insertion dans les branches différentielles principales de transistors cascode (bases reliées à un potentiel fixe commun) et addition à la sortie de deux branches différentielles supplémentaires croisées par rapport aux branches principales. Ce type d'amplificateur est connu pour avoir une bonne linéarité sur une large plage de tensions d'entrée.

A la figure 9 on a représenté un exemple de réalisation pratique de la cellule d'interpolation CI1 avec ses cinq amplificateurs différentiels et ses circuits de multiplexage. Dans cet exemple, l'amplificateur différentiel proprement dit est celui de la figure 2, mais les résistances de charge reliées aux collecteurs des transistors sont séparées de ces collecteurs. c'est-à-dire que les circuits de multiplexage sont intercalés entre les transistors et les résistances de charge.

Cela permet d'avoir cinq paires de transistors avec trois paires de résistances de charge seulement ; le rôle du multiplexeur est de connecter les trois paires de résistances de charge à trois paires de transistors sélectionnées parmi les cinq. Les collecteurs des autres transistors sont reliés alors à la tension d'alimentation Vcc.

Le schéma de la figure 9 doit bien entendu être modifiée si des amplificateurs du type de la figure 8 sont utilisés : les transistors cascodes et les paires différentielles supplémentaires sont alors reliés aux trois paires de résistances de charge à la sortie du multiplexeur.

Le gain des amplificateurs différentiels des circuits d'interpolation est de préférence égal à 2 (gain de tension différentielle de sortie sur tension différentielle d'entrée). Pour expliquer ce choix, on va revenir d'abord sur les figures 4 et 6.

Sur la figure 6, on a représenté les signaux produits par les cinq amplificateurs différentiels du circuit d'interpolation CIS1. Ces signaux ont été représentés avec la même pente (en fonction de Vin) que les signaux d'entrée de cet étage, c'est-à-dire les signaux V1A0, V1B0, etc. représentés à la figure 4. Ceci correspondrait au cas où les amplificateurs différentiels du circuit CIS1 ont un gain unitaire.

Dans ce cas, on peut facilement voir que les niveaux de tension de croisement des courbes de variation ne sont pas constantes d'un étage au suivant : par exemple, les paires croisées adjacentes, à la sortie des amplificateurs A1, A2, A3, se croisent pour une tension Vm0; les paires croisées adjacentes à la sortie du circuit CIS1 se croisent pour une tension Vm1 telle que (Vm1-Vm) soit deux fois plus faible que (Vm0-Vm); et les paires croisées adjacentes à la sortie de l'étage suivant CIS2 se croisent pour une tension Vm2 telle que (Vm2-Vm) soit deux fois plus faible que (Vm1-Vm), etc.

Les transistors des amplificateurs des différents étages ne fonctionnent donc pas dans les mêmes conditions.

On préfère donc augmenter la pente des courbes de variation en fonction de Vin d'un étage au suivant pour remonter le niveau de croisement à chaque fois à peu près au même niveau Vm0. Ceci peut être obtenu facilement en prévoyant un gain d'environ deux pour les amplificateurs différentiels des différents circuits d'interpolation.

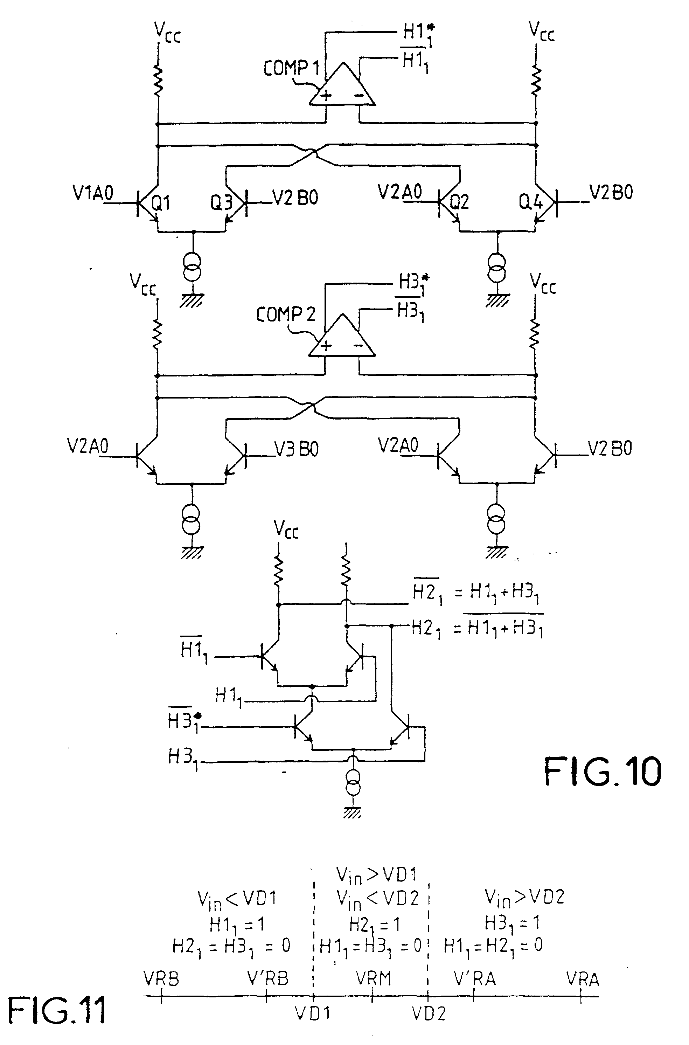

Le circuit de décision CD1 est représenté en détail à la figure 10. Il produit des signaux logiques H1₁, H2₁, H3₁ à partir d'additions analogiques entre certains des signaux d'entrée V1A0, V1B0, V2A0, V2B0, V3A0, V3B0. Ces signaux dépendent de Vin et leurs sommes dépendent de Vin (sauf la somme des signaux d'une même paire).

Si on se réfère d'abord à la figure 11 pour expliquer le principe du circuit de décision, on peut remarquer la chose suivante : pour connaître la meilleure des trois gammes de tension de rang 1 à sélectionner (celle qui encadre le mieux Vin) lorsque les tensions de référence sont VRB, VR'B, VRM, V'RA et VRA, il faut déterminer la position de Vin par rapport aux tensions VD1 et VD2 situées respectivement au mileu des demi-intervalles (V'RB, VRM) et (VRM, V'RA).

En effet, si Vin est inférieur à VD1 c'est la gamme inférieure VRB, VRM qu'il faut sélectionner car Vin est plus près du milieu de cette gamme que du milieu des autres gammes. Si Vin est compris entre VD1 et VD2 il faut sélectionner la gamme centrale V'RB, V'RA car Vin est plus près du milieu de cette gamme que du milieu des autres gammes. Et si Vin est supérieur à VD2 il faut sélectionner la gamme supérieure VRM, VRA.

Or, pour comparer Vin à VD1 et VD2, alors qu'on ne dispose pas directement de VD1 et VD2 mais seulement des signaux d'entrée du circuit CIS1, on peut combiner certains de ces signaux d'entrée dans des amplificateurs différentiels agissant comme sommateurs algébriques.

Ainsi, le circuit qui élabore la comparaison de Vin avec VD1 (partie supérieure de la figure 10) est constitué par une double paire de branches différentielles croisées utilisant deux résistances de charge commune. Les quatre transistors de cette double paire reçoivent comme tensions d'entrée les tensions V1A0 et V2A0 (transistor Q1 et Q2 connectés à l'une des résistances de charge) et V2B0 (transistors Q3 et Q4 connectés à l'autre résistance de charge). Les deux sorties de cette double paire différentielle vont sur un comparateur COMP1 délivrant le signal logique H1₁ et son complément logique. La double paire différentielle produit en effet un signal dont la variation avec Vin est monotone croissante, négative lorsque (V2B0 - V2A0) + (V2B0 - V1A0) est négatif puis positive lorsque (V2B0 - V2A0) + (V2B0 - V1A0) est positif.

Or si on examine les courbes de la figure 4, il est facile de voir que la somme algébrique ci-dessus s'annule lorsque Vin passe par le milieu de l'intervalle V'RB, VRM, donc par VD1. Le comparateur COMP1 bascule donc lorsque Vin devient supérieur à VD1.

De même, H3₁ est produit par un circuit similaire recevant V2A0, V2B0 et V3B0 et fournissant à la sortie d'un comparateur COMP2 le signal H3₁ et son complément, qui basculent lorsque Vin devient supérieur à VD2. Enfin, un additionneur logique réalise H2₁ qui est le complément logique de la somme H1₁ + H3₁ et qui représente le fait que Vin est situé ou non entre VD1 et VD2.

Finalement, comme cela est rappelé sur la figure 11, le signal logique H1₁ est à un niveau 1, représentant la sélection de gamme inférieure (VRB, VRM) lorsque Vin est inférieur à VD1, et à un niveau 0 lorsque Vin est supérieur à VD1. Le signal logique H2₁ est à un niveau 1, représentant la sélection de la gamme centrale (V'RB, V'RA) lorsque Vin est compris entre VD1 et VD2, et à un niveau 0 lorsque Vin est hors de cet intervalle. Et le signal H3₁ est à un niveau 1, représentant la sélection de la gamme supérieure (VRM, VRA) lorsque Vin est supérieur à VD2, et à un niveau 0 dans le cas contraire.

Pour les autres circuits d'interpolation et de sélection, c'est la même chose, les signaux H1ₖ, H2ₖ, H3ₖ pour le circuit de rang k représentant les trois sélections de gamme possibles de rang k.

Les signaux de sélection de gamme H1ₖ, H2ₖ, H3ₖ sont utilisés par le décodeur DEC (figure 1) pour déterminer la valeur numérique de Vin.

La signification de ce décodage est la suivante ; étant donné le recouvrement des gammes, la valeur des signaux H1ₖ, H2ₖ, H3ₖ ne détermine pas directement une gamme de valeurs de Vin : l'information a une signification non ambiguë si la gamme supérieure ou la gamme inférieure de rang k sont sélectionnées (H2ₖ = 0); mais elle est ambiguë si c'est la gamme centrale de rang k qui est sélectionnée (H2ₖ = 1).

Dans ce dernier cas, la sélection de gamme de rang k+1 lève cette ambiguïté, sauf si c'est encore la gamme centrale qui est sélectionnée. Ainsi de suite, en utilisant la combinaison de l'information de sélection de gamme de rang k et l'information de sélection de gamme de rang k+1, on lève l'ambiguïté sur la plage dans laquelle se situe Vin. Pour le dernier rang n, si c'est la gamme centrale qui est sélectionnée, on lève l'ambiguïté (qui ne concerne qu'un bit de poids le plus faible de la conversion analogique-numérique) en comparant les signaux de sortie V2An et V2Bn du circuit d'interpolation ClSn de rang n (comparateur CMPn de la figure 1). Cette comparaison indique si Vin est plus proche de la gamme inférieure ou plus proche de la gamme supérieure même si Vin est dans la gamme centrale.

Le principe du décodeur DEC est alors le suivant : le bit de poids fort B0 de la conversion est 1 si H3₁ est égal à 1 car Vin est alors supérieur à VD2. Le bit de poids fort B0 est zéro si H3₁ et H2₁ sont égaux à zéro (ce qui équivaut à H1₁ = 1), car alors Vin est inférieur à VD1. Mais si H3₁ est égal à 0 et H2₁ est égal à 1 il y a ambiguité et cette ambiguité ne se lève qu'en examinant H3₂.

Le bit B0 peut donc être obtenu par l'addition de H3₁ et d'un bit qui lui-même dépend de H3₂ et H2₁, en notant par ailleurs que l'addition de H3₂ et H2₁ fournit elle-même, sous réserve d'une ambiguité lorsque H3₂ = 0 et H2₂ = 1, le bit de poids immédiatement inférieur B1.

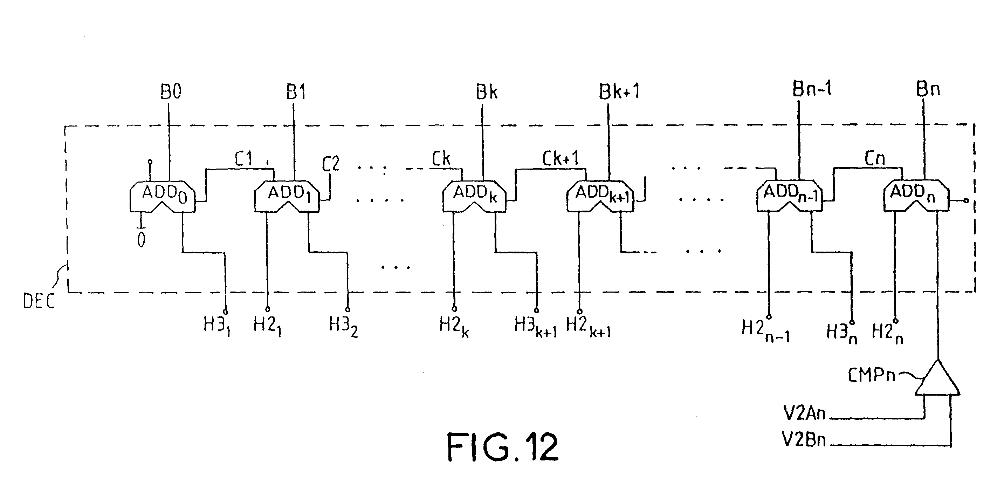

La structure de décodeur proposée ici, représentée à la figure 12, comporte donc :
- un additionneur ADD0 de poids fort qui reçoit H3₁ et la retenue C1 d'un additionneur ADD1 de poids immédiatement inférieur, et qui fournit B0;
- un additionneur ADD1 qui reçoit H2₁ en provenance du circuit de décision CD1 et H3₂ en provenance du circuit de décision CD2, et la retenue C2 d'un additionneur suivant ADD2, et qui fournit le bit B1 de la conversion et la retenue C1;
- etc, un additionneur ADDk, recevant H2ₖ et H3ₖ₊₁ et la retenue Cₖ₊₁ de l'additionneur suivant, et fournissant le bit Bₖ de la conversion et une retenue Cₖ,
- et, pour le dernier étage, de rang n, un additionneur ADDn recevant H2ₙ et un bit de levée d'ambiguïté final issu de la sortie du comparateur CMPn, cet additionneur fournissant le bit Bn de la conversion et une retenue Cn pour l'étage précédent.

Le lever d'ambiguité final, pour le poids le plus faible, est en effet réalisé à l'aide du niveau de Vin par rapport à la référence de tension principale médiane élaborée par le dernier circuit d'interpolation CISn, et cette comparaison est fournie par le comparateur CMPn qui reçoit les signaux V2An et V2Bn.

On a décrit ainsi complètement le circuit de la figure 1, dans une réalisation préférentielle. On notera que des variantes de réalisation peuvent être prévues sans sortir du cadre de l'invention et ces variantes vont maintenant être décrites.

Tout d'abord on notera que le circuit dans son ensemble peut être réalisé en technologie MOS, c'est-à-dire en utilisant exclusivement des transistors à effet de champ à grille isolée en remplacement des transistors bipolaires. On sait en effet réaliser des amplificateurs différentiels linéaires en technologie MOS.

Ensuite, le convertisseur analogique-numérique peut comprendre seulement deux ou trois étages de circuits d'interpolation tels que ceux qui ont été décrits ci-dessus; les poids les plus faibles de la conversion peuvent en effet être obtenus par des circuits d'interpolation en cascade de l'art antérieur, ou par d'autres moyens encore. De même, les poids forts (poids plus forts que B0) peuvent être, comme on l'a déjà rappelé, obtenus à partir de convertisseurs grossiers rapides.

Par ailleurs, les circuits d'interpolation et sélection décrits en détail dans l'exemple de réalisation préféré comportent cinq amplificateurs différentiels et utilisent un multiplexeur pour sélectionner trois paires de signaux parmi cinq paires. Mais on peut prévoir, pour réduire un peu le nombre d'étages en cascade au prix d'une complexité un peu plus grande de ces étages, qu'un ou plusieurs des circuits d'interpolation et de sélection comportent un nombre d'amplificateurs différentiels plus élevé et permettent de sélectionner trois paires de signaux parmi 2^{p} +1.

Pratiquement, p peut être égal à 3 (on aurait p = 2 dans l'exemple décrit précédemment). Cela signifie qu'avec trois paires de signaux d'entrée, on crée neuf paires de signaux, qui correspondent chacune à une tension de référence fictive, et on sélectionne trois références adjacentes définissant un intervalle qui encadre le mieux possible Vin. Ces trois références permettent de définir trois paires de signaux de sortie, qui seront appliquées comme entrées à l'étage suivant.

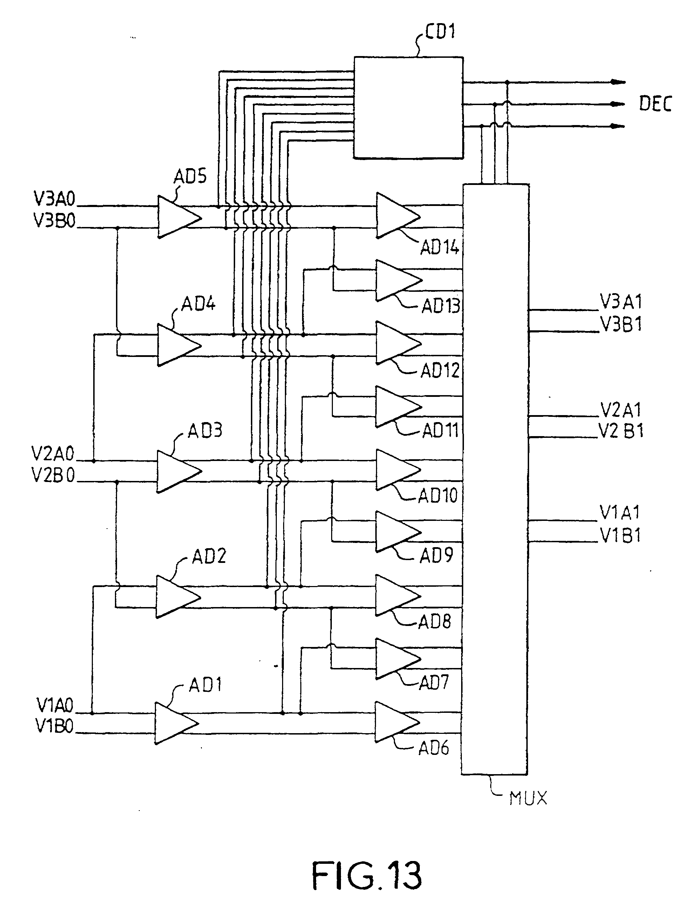

La figure 13 représente l'architecture générale d'un circuit d'interpolation et de décision qui fonctionne avec p = 3.

Ce circuit comporte deux étages successifs d'amplification et un seul multiplexeur (MUX) en sortie du deuxième étage pour sélectionner trois paires parmi neuf. Le premier étage comporte cinq amplificateurs (AD1 à AD5) analogues à ceux de la figure 7; ces amplificateurs reçoivent les trois paires de signaux d'entrée non croisées et deux paires croisées, comme expliqué en référence à la figure 7. Le deuxième étage comporte neuf amplificateurs AD6 à AD14 et reçoit les cinq paires non croisées issues du premier étage et quatre paires croisées issues également du premier étage. Les gains des amplificateurs AD1 à AD14 sont de préférence d'environ 2. Les neuf amplificateurs du deuxième étage produisent des paires de signaux symétriques, monotones, qui définissent neuf références de tension fictives régulièrement espacées dans un intervalle dont les bornes sont les références principales définies par les trois paires de signaux d'entrée. Le circuit de décision CD1 choisit trois de ces neuf références, donc trois paires de signaux de sortie parmi neuf paires possibles. Les trois références fictives ainsi choisies, qui deviennent références principales pour l'étage suivant et dont l'intervalle est quatre fois plus faible que l'intervalle entre les tensions de références principales définies par les signaux d'entrée, sont celles qui encadrent de plus près la tension d'entrée Vin. Le circuit de décision qui permet de choisir ces trois références parmi neuf effectue des soustractions analogiques et des comparaisons à paritr des cinq paires de signaux d'entrée du deuxième étage, selon le principe expliqué en référence aux figures 10 et 11, pour établir des signaux logiques (trois bits pour sept possibilités) qui indiquent la sélection effectuée. Ces signaux logiques sont directement liés à la gamme dans laquelle se situe Vin et peuvent être décodés pour fournir une indication sur la valeur numérique de Vin. Le schéma de la figure 7 réduit le nombre d'étages en cascade puisqu'une gamme de tensions de rang k a une amplitude quatre fois plus faible qu'une gamme de rang k-1, mais c'est bien sûr au prix d'une complexité supérieure de chaque étage.

## Revendications

1. Convertisseur analogique-numérique qui possède une entrée pour recevoir une tension analogique Vin à convertir, **caractérisé en ce qu'**il comporte une succession de circuits d'interpolation et de sélection en cascade (CIS1, CIS2 ...), avec au moins un circuit d'interpolation et de sélection de rang k comportant
- trois paires d'entrées recevant comme signaux d'entrée trois paires de signaux de sortie (V3A1, V3B1, V2A1, V2B1, V1A1, V1B1) d'un circuit d'interpolation précédent, les signaux d'une paire ayant des valeurs égales lorsque la tension Vin est égale à l'une de trois tensions de références principales de rang k-1 associées chacune à une paire respective, ces trois tensions définissant entre elles un intervalle composé de deux demi-intervalles de tension de rang k-1,
- des moyens pour établir, à partir des signaux d'entrée, P = 2^{P}+1 paires de signaux d'interpolation avec p > 1 et P > 3, chaque paire comprenant deux signaux d'interpolation qui varient symétriquement et de manière monotone en fonction de la tension Vin, les signaux d'une paire étant égaux lorsque la tension Vin est égale à une tension de référence associée à cette paire, les P tensions de référence associées aux P paires étant sensiblement d'une part les trois tensions de référence principales de rang k-1 et d'autre part (P - 3) tensions de référence intermédiaires, les P tensions de référence permettant de définir 2^{p} - 1 intervalles de tension de largeur égale à 1/2^{p-1} intervalle de rang k-1,
- des moyens de décision pour déterminer en fonction des niveaux des trois paires de signaux d'entrée quel est, parmi les 2^{p}-1 intervalles, l'intervalle de tensions qui encadre de plus près la tension d'entrée Vin, cet intervalle étant composé de deux demi-intervalles délimités par trois tensions de référence parmi P, ces trois tensions étant appelées tensions de référence de rang k,
- et des moyens pour sélectionner, parmi les P paires, les trois paires (V3A2, V3B2, V2A2, V2B2, V1A2, V1B2) associées aux trois tensions de référence de rang k, pour les appliquer à la sortie du circuit d'interpolation de rang k.

2. Convertisseur analogique-numérique selon la revendication 1, **caractérisé en ce que** les moyens pour établir des signaux d'interpolation comprennent au moins un étage d'amplificateurs différentiels en parallèle, ces amplificateurs ayant chacun un gain d'environ 2.

3. Convertisseur analogique-numérique selon l'une des revendications 1 et 2, **caractérisé en ce que** p=2 et P=5, et **en ce que** les cinq tensions de référence associées aux cinq paires de signaux d'interpolation sont d'une part les trois tensions de référence principales de rang k-1 et d'autre part deux tensions de référence intermédiaires situées au milieu des demi-intervalles définis par les trois tensions de référence principales de rang k-1, ces cinq tensions de référence. définissant entre elles trois intervalles de tension de largeur égale à un des demi-intervalles de tension de rang k-1, lesdits moyens de sélection agissant pour sélectionner parmi les cinq paires de signaux d'interpolation les trois paires telles que les signaux d'une paire soient égaux lorsque la tension Vin est égale à l'une des tensions de référence principales de rang k.

4. Convertisseur selon la revendication 3, **caractérisé en ce que** le circuit d'interpolation et de sélection de rang 1 reçoit comme signaux d'entrée les sorties différentielles de trois amplificateurs différentiels (A1, A2, A3) qui reçoivent sur une première entrée la tension à convertir Vin, et sur une deuxième entrée chacun une de trois références de tension primaires (VRB, VRM, VRA), ces amplificateurs fournissant chacun deux tensions de sortie qui varient symétriquement et de manière monotone en fonction de la tension à convertir Vin.

5. Convertisseur selon la revendication 4, **caractérisé en ce que** les références de tension primaires sont espacées les unes des autres de telle sorte que les courbes de variation de tensions de sortie de l'amplificateur correspondant à la référence centrale (VRM) croisent les courbes de variation des tensions de sortie des deux autres amplificateurs dans une zone de variation linéaire de ces tensions de sortie.

6. Convertisseur selon l'une des revendications 3 à 5, **caractérisé en ce que** le circuit d'interpolation et de sélection de rang k comporte cinq amplificateurs différentiels, un circuit de décision, et un circuit de sélection commandé par le circuit de décision pour orienter vers les sorties du circuit les signaux de sortie de trois amplificateurs différentiels sélectionnés parmi les cinq.

7. Convertisseur selon l'une des revendications 3 à 6, **caractérisé en ce que** les trois paires de tension de sortie sélectionnées ont des courbes de variation en fonction de Vin qui se croisent dans une zone linéaire de ces courbes.

8. Convertisseur analogique-numérique selon l'une des revendications 3 à 7, **caractérisé en ce qu'**il comporte un circuit de décodage recevant des signaux logiques en provenance des moyens de décision des circuits d'interpolation et de sélection, pour fournir des bits numériques représentant une valeur numérique de Vin.

9. Convertisseur selon la revendication 8, **caractérisé en ce que** le circuit de décodage comporte au moins un additionneur de rang k, fournissant un bit de résultat de conversion de rang k, et recevant comme entrées un bit d'un signal logique de décision d'un circuit d'interpolation de rang k, un autre bit d'un signal logique de décision en provenance d'un circuit d'interpolation de rang k+1, et une retenue d'addition d'un additionneur de rang k+1.

10. Procédé de conversion analogique-numérique d'une tension d'entrée Vin, utilisant plusieurs circuits d'interpolation en cascade (CIS1, CIS2 ...), **caractérisé en ce que** :
- on applique à l'entrée d'un circuit d'interpolation de rang k trois paires de signaux analogiques issus de trois paires de sorties (V3A1, V3B1, V2A1, V2B1, V1A1, V1B1) d'un circuit d'interpolation précédent de rang k-1, les signaux d'une paire ayant des valeurs égales lorsque la tension Vin est égale à l'une de trois tensions de références principales de rang k-1 associées chacune à une paire respective, ces trois tensions définissant entre elles un intervalle composé de deux demi-intervalles de tension de rang k-1,
- on produit, à partir de ces trois paires de signaux, P = 2^{P}+1 paires de signaux d'interpolation (p>1, P>3), chaque paire comprenant deux signaux d'interpolation qui varient symétriquement et de manière monotone en fonction de la tension Vin, les signaux d'une paire étant égaux lorsque la tension Vin est égale à une tension de référence associée à cette paire, les P tensions de référence associées aux P paires étant sensiblement d'une part les trois tensions de référence principales de rang k-1 et d'autre part au moins deux tensions intermédiaires situées au milieu des demi-intervalles définis par les trois tensions de référence principales de rang k-1, ces P tensions de référence permettant de définir 2^{p} - 1 intervalles de tension de largeur égale à 1/2^{p-1} intervalle de rang k-1,
- on détermine en fonction des niveaux des trois paires de signaux d'entrée quel est, parmi les 2^{p} - 1 intervalles, l'intervalle de tensions qui encadre de plus près la tension d'entrée Vin, cet intervalle étant composé de deux demi-intervalles délimités par trois tensions de référence parmi P, ces trois tensions étant appelées tensions de référence de rang k,
- on sélectionne, parmi les P paires, les trois paires (V3A2, V3B2, V2A2, V2B2, V1A2, V1B2) associées aux trois tensions de référence de rang k, et on applique ces trois paires à la sortie du circuit d'interpolation de rang k.

## Patentansprüche

1. Analog/Digitalwandler, der einen Eingang zum Empfang einer umzuwandelnden analogen Spannung Vin besitzt, **dadurch gekennzeichnet, daß** er eine kaskadenartige Folge von Interpolations- und Auswahlschaltungen (CIS1, CIS2, ...) mit mindestens einer Interpolations- und Auswahlschaltung des Rangs k besitzt, die aufweist:
- drei Paare von Eingängen, die als Eingangssignale drei Paare von Ausgangssignalen (V3a₁, V3B₁; V2A₁, V2B₁; V1A₁, V1B₁) einer vorausgehenden Interpolationsschaltung empfangen, wobei die Signale eines Paars gleiche Werte haben, wenn die Spannung Vin einer der drei Hauptbezugsspannungen des Rangs k-1 gleicht, die je einem entsprechenden Paar zugeordnet sind, und wobei diese drei Spannungen miteinander ein aus zwei Halbintervallen der Spannung des Rangs k-1 zusammengesetztes Intervall definieren,
- Mittel, um ausgehend von den Eingangssignalen P=2^{P}+1 Paare von Interpolationssignalen zu erzeugen (p>1; P>3), wobei zu jedem Paar zwei Interpolationssignale gehören, die symmetrisch und monoton abhängig von der Spannung Vin variieren, und die Signale eines Paares gleich sind, wenn die Spannung Vin einer diesem Paar zugeordneten Bezugsspannung gleicht, und wobei die P den P Paaren zugeordneten Bezugsspannungen im wesentlichen einerseits die drei Hauptbezugsspannungen des Rangs k-1 und andrerseits P-3 Zwischenbezugsspannungen bilden und die P Bezugsspannungen 2^{p}-1 Spannungsintervalle definieren können, deren Breite einem Bruchteil 1/2^{p-1} des Intervalls des Rangs k-1 entspricht,
- Entscheidungsmittel, um abhängig von den Pegeln der drei Eingangs-Signalpaare zu bestimmen, welches der 2^{p}-1 Intervalle das Spannungsintervall ist, das am besten die Eingangsspannung Vin einrahmt, wobei dieses Intervall aus zwei Halbintervallen besteht, die durch drei von P Bezugsspannungen begrenzt werden und diese drei Spannungen die Bezugsspannungen des Rangs k genannt werden,
- und Mittel, um aus den P Paaren diejenigen drei Paare (V3a₂, V3B₂; V2A₂, V2B₂; V1A₂, V1B₂) auszuwählen, die den drei Bezugsspannungen des Rangs k zugeordnet sind, um sie an den Ausgang der Interpolationsschaltung des Rangs k anzulegen.

2. Analog/Digitalwandler nach Anspruch 1, **dadurch gekennzeichnet, daß** die Mittel zur Bildung der Interpolationssignale mindestens eine Stufe von parallelen Differentialverstärkern enthält, die je einen Verstärkungsgrad von etwa 2 besitzen.

3. Analog/Digitalwandler nach einem der Ansprüche 1 und 2, **dadurch gekennzeichnet, daß** gilt p=2 und P=5 und daß die fünf den fünf Paaren von Interpolationssignalen zugeordneten Bezugsspannungen einerseits die drei Hauptbezugsspannungen des Rangs k-1 und andrerseits zwei Zwischenbezugsspannungen sind, die in der Mitte der Halbintervalle liegen, die durch die drei Hauptbezugsspannungen des Rangs k-1 definiert werden, wobei diese fünf Bezugsspannungen zwischen sich drei Spannungsintervalle einer Breite gleich der eines Halbintervalls der Rangs k-1 definieren und die Auswahlmittel unter den fünf Paaren von Interpolationssignalen drei Paare so auswählen, daß die Signale eines Paares gleich sind, wenn die Spannung Vin einer der Hauptbezugsspannungen des Rangs k gleicht.

4. Analog/Digitalwandler nach Anspruch 3, **dadurch gekennzeichnet; daß** die Interpolations- und Auswahlschaltung des Rangs 1 als Eingangssignale die Differentialausgänge von drei Differentialverstärkern (A1, A2, A3) empfängt, die ihrerseits an einem ersten Eingang die umzuwandelnde Spannung Vin und an einem zweiten Eingang je eine von drei Hauptbezugsspannungen (VRB, VRM, VRA) empfangen und je zwei Ausgangsspannungen liefern, die symmetrisch und monoton abhängig von der umzuwandelnden Spannung Vin variieren.

5. Analog/Digitalwandler nach Anspruch 4, **dadurch gekennzeichnet, daß** die Hauptbezugsspannungen voneinander solche Abstände besitzen, daß die Kurvenverläufe von Ausgangsspannungen des der zentralen Hauptbezugsspannung (VRM) entsprechenden Verstärkers die Kurvenverläufe der Ausgangsspannungen der beiden anderen Verstärker in einer linearen Zone dieser Ausgangsspannungen kreuzen.

6. Analog/Digitalwandler nach einem der Ansprüche 3 bis 5, **dadurch gekennzeichnet, daß** die Interpolations- und Auswahlschaltung des Rangs k fünf Differentialverstärker, eine Entscheidungsschaltung und eine Auswahlschaltung enthält, wobei letztere durch die Entscheidungsschaltung gesteuert wird, um die Ausgangssignale von drei unter den fünf vorhandenen Verstärkern ausgewählten Differentialverstärkern an die Ausgänge der Schaltung zu lenken.

7. Analog/Digitalwandler nach einem der Ansprüche 3 bis 6, **dadurch gekennzeichnet, daß** die drei ausgewählten Paare von Ausgangsspannungen Kurvenverläufe abhängig von Vin besitzen, die sich in einer linearen Zone dieser Verläufe kreuzen.

8. Analog/Digitalwandler nach einem der Ansprüche 3 bis 7, **dadurch gekennzeichnet, daß** er eine Dekodierschaltung enthält, die logische Signale von den Entscheidungsmitteln der Interpolations- und Auswahlschaltungen empfängt und digitale Bits liefert, die einen digitalen Wert von Vin darstellen.

9. Analog/Digitalwandler nach Anspruch 8, **dadurch gekennzeichnet, daß** die Dekodierschaltung mindestens einen Addierer des Rangs k enthält, der ein Bit des Ergebnisses der Umwandlung für den Rang k liefert und am Eingang ein Bit eines logischen Entscheidungssignals von einer Interpolationsschaltung des Rangs k, ein weiteres Bit eines logischen Entscheidungssignals von einer Interpolationsschaltung des Rangs k+1 und einen Additions-Übertrag von einem Addierer des Rangs k+1 empfängt.

10. Verfahren zur Analog/Digitalumwandlung einer Eingangsspannung Vin, das mehrere Interpolationsschaltungen (CIS1, CIS2, ...) in Kaskade verwendet, **dadurch gekennzeichnet, daß**
- man an den Eingang einer Interpolationsschaltung des Rangs k drei Paare von Analogsignalen anlegt, die von drei Paaren von Ausgängen (V3a₁/V3B₁, V2A₁/V2B₁, V1A₁/V1B₁) einer vorhergehenden Interpolationsschaltung des Rangs k-1 stammen, wobei die Signale eines Paars gleiche Werte haben, wenn die Spannung Vin einer der drei Hauptbezugsspannungen des Rangs k-1 gleicht, die je einem Paar zugeordnet sind, und wobei diese drei Spannungen zwischen sich ein aus zwei Halbintervallen des Rangs k-1 zusammengesetztes Spannungsintervall definieren,
- man ausgehend von diesen drei Signalpaaren P=2^{p}+1 Paare von Interpolationssignalen (p>1, P>3) erzeugt, die je zwei Interpolationssignale enthalten, welche symmetrisch und monoton abhängig von der Spannung Vin variieren, wobei die Signale eines Paares gleich sind, wenn die Spannung Vin einer diesem Paar zugeordneten Bezugsspannung gleicht, und die P den P Paaren zugeordneten Bezugsspannungen im wesentlichen einerseits die drei Hauptbezugsspannungen des Rangs k-1 und andrerseits mindestens zwei Zwischenspannungen entsprechen, die in der Mitte der durch die drei Hauptbezugsspannungen des Rangs k-1 definierten Halbintervalle liegen, wobei diese P Bezugsspannungen 2^{p}-1 Spannungsintervalle definieren können, deren Breite einem Bruchteil 1/2^{p-1} des Intervalls des Rangs k-1 gleicht,
- man abhängig von den Pegeln der drei Eingangssignalpaare bestimmt, welches unter den 2^{p}-1 Intervallen das Spannungsintervall ist, das die Eingangsspannung Vin am besten einrahmt, wobei dieses Intervall aus zwei Halbintervallen gebildet wird, die durch drei der P Bezugsspannungen begrenzt wird, welche Hauptbezugsspannungen des Rangs k genannt werden,
- man unter den P Paaren die drei Paare (V3a₂/V3B₂, V2A₂/V2B₂, V1A₂/V1B₂) auswählt, die den drei Bezugsspannungen des Rangs k zugeordnet sind, und man diese drei Paare an den Ausgang der Interpolationsschaltung des Rangs k anlegt.

## Claims

1. An analog to digital converter that possesses an input to receive an analog voltage Vin to be converted, said converter comprising a succession of cascade-connected interpolation and selection circuits (CIS1, CIS2 ...) with at least one k order interpolation and selection circuit comprising:
- three pairs of inputs receiving, as input signals, three pairs of output signals (V3A1, V3B1, V2A1, V2B1, V1A1, V1B1) from a preceding interpolation circuit, the signals of a pair having equal values when the voltage Vin is equal to one of three k-1 order main reference voltages each associated with a respective pair, these three voltages mutually defining an interval consisting of two k-1 order voltage half intervals,
- means for the setting up, on the basis of the input signals, of P=2^{*p*}+1 pairs of interpolation signals (p>1, P>3), each pair comprising two interpolation signals that vary symmetrically and monotonically as a function of the voltage Vin, the signals of one pair being equal when the voltage Vin is equal to a reference voltage associated with this pair, the P reference voltages asssociated with the P pairs being substantially, firstly, the three k-1 order main reference voltages and, secondly, (P-3) intermediate reference voltages, the P reference voltages enabling the definition of 2^{*p*}-1 voltage intervals with a width equal to ½^{*p*}⁻¹ interval corresponding to the k-1 order,
- decision means for the determining, as a function of the levels of three pairs of input signals, of that voltage interval, among the 2^{*p*}-1 intervals, that most closely surrounds the input voltage Vin, this interval consisting of two half-intervals demarcated by three out of P reference voltages, these three voltages being called k order reference voltages,
- and means for the selection, from among the P pairs, of the three pairs (V3A2, V3B2, V2A2, V2B2, V1A2, V1B2) associated with the three k order reference voltages, to apply them to the output of the k order interpolation circuit.

2. Analog to digital converter according to Claim 1, **characterized in that** the means for setting up interpolation signals comprise at least one parallel-connected differential amplifier stage, these amplifiers each having a gain of about 2.

3. Analog to digital converter according to one of Claims 1 and 2, **characterized in that** p=2 and P=5, and **in that** the five reference voltages associated with the five pairs of interpolation signals are, on the one hand, the three k-1 order main reference voltages and, on the other hand, two intermediate reference voltages lying in the middle of the half-intervals defined by the three k-1 order main reference voltages, these five reference voltages between them defining three voltage intervals of width equal to one of the k-1 order voltage half-intervals, the said selection means acting so as to select from among the five pairs of interpolation signals the three pairs such that the signals of one pair are equal when the voltage Vin is equal to one of the main k order reference voltages.

4. Converter according to Claim 3, **characterized in that** the first order interpolation and selection circuit receives, as input signals, the differential outputs from three differential amplifiers (A1, A2, A3) which receive the voltage Vin to be converted at a first input, each of them receiving, at a second input, one of three primary voltage references (VRB, VRM, VRA), these amplifiers each giving two output voltages that vary symmetrically and monotonically as a function of the voltage Vin to be converted.

5. Converter according to Claim 4, **characterized in that** the primary voltage references are spaced out with respect to one another so that the variation curves of output voltages from the amplifier corresponding to the central reference (VRM) intersect the variation curves of the output voltages from the two other amplifiers in a zone of linear variation of these output voltages.

6. Converter according to any of Claims 3 to 5, **characterized in that** the k order interpolation and selection circuit comprises five differential amplifiers, one decision circuit and one selection circuit controlled by the decision circuit for the orientation, to the outputs of the circuit, of the output signals from three differential amplifiers selected from among the five amplifiers.

7. Converter according to any one of Claims 3 to 6, **characterized in that** the three pairs of selected output voltages have curves of variation as a function of Vin that intersect in a linear zone of these curves.

8. Analog to digital converter according to any one of Claims 3 to 7, **characterized in that** it comprises a decoding circuit receiving logic signals coming from decision means of the interpolation and selection circuits to provide digital bits representing a digital value of Vin.

9. Converter according to Claim 8, **characterized in that** the decoding circuit comprises at least one k order adder giving a k order conversion result bit and receiving, as inputs, one bit of a decision logic signal from a k order interpolation circuit, another bit of a decision logic signal coming from a k+1 order interpolation circuit and an addition carry value from a k+1 order adder.

10. Method for the analog to digital conversion of an input voltage Vin using several cascade-connected interpolation circuits (CIS1, CIS2 ...), **characterized in that**:
- there are applied, to the input of a k order interpolation circuit, three pairs of analog signals coming from three pairs of outputs (V3A1, V3B1, V2A1, V2B1, V1A1, V1B1) of a preceding k-1 order interpolation circuit, the signals of a pair having equal values when the voltage Vin is equal to one of three k-1 order main reference voltages each associated with a respective pair, these three voltages mutually defining an interval formed by two k-1 order voltage half-intervals,
- there are produced, from these three pairs of signals, P=2^{*p*}+1 pairs of interpolation signals (p>1, P>3), each pair comprising two interpolation signals that vary symmetrically and monotonically as a function of the voltage Vin, the signals of a pair being equal when the voltage Vin is equal to a reference voltage associated with this pair, the P reference voltages associated with the P pairs being substantially, firstly, the three k-1 order main reference voltages and, secondly, at least two intermediate voltages located in the middle of the half-intervals defined by the three k-1 order main reference voltages, these P reference voltages enabling the definition of 2^{*p*}-1 voltage intervals with a width equal to ½^{*p*}⁻¹ interval corresponding to the k-1 order,
- an operation is carried out to determine, as a function of the levels of the three pairs of input signals, that voltage interval, of the 2^{*p*}-1 intervals, that most closely surrounds the input voltage Vin, this interval being formed by two half-intervals demarcated by three out of P reference voltages, these three voltages being called k order reference voltages,
- a selection is made, among the P pairs, of the three pairs (V3A2, V3B2, V2A2, V2B2, V1A2, V1B2) associated with the three k order reference voltages, and these three pairs are applied to the output of the k order interpolation circuit.
